# EUROPEAN PATENT APPLICATION

(11) **EP 1 304 807 A1**
(43) Date of publication of application: **23.04.2003**
(21) Application number: 02023418.3
(22) Date of filing: 19.10.2002
(51) Int. Cl.: H03M 1/12, H02J 7/00

(54) **Method and apparatus for flexible analog-to-digital conversion**

(30) Priority: 16.05.2002 US 147250; 19.10.2001 US 335137 P
(71) Applicant: Microchip Technology Incorporated, Chandler, AZ 85224-6199 (US)
(72) Inventor: Enochson, Mark P., Plano, Texas 75093 (US); Vernon, Jimmie C., Carrolton, Texas 75007 (US); Zander, Gary V., Fairview, Texas 75069 (US); Delrossi, Richard, Dallas, Texas 75214 (US)
(74) Representative: Grubert, Andreas

(57) **Abstract**

An analog-to-digital converter (ADC) includes storage for one or more configuration parameter values. Configuration parameter values stored in the storage locations are used by control logic to configure the ADC's conversion mechanism. The configuration values may be arranged in lists that the control logic cycles through in order to modify the configuration of the ADC's conversion mechanism. The control logic may change from one list, or series of lists, to another in order to adapt the ADC to changing circumstances. The changing circumstances may include the changing state of charge in a battery monitoring application.

## Description

The invention relates to analog-to-digital conversion and, more particularly, to flexible control of analog-to-digital converters.

In many applications analog-to-digital converters (ADCs) may be configured to convert analog input signals to digital representations of the analog input signals in a substantially continuous fashion; without adjusting the ADC configuration. For example, in a digital communications application an ADC may operate at top speed on a continuous analog input stream from a single signal. Once the ADC is configured, by setting resolution and conversion time, for example, the ADC converts a sample of the input stream. After converting the sample, the ADC may provide an indication that the conversion is complete. At that time, the digital information may be read out of the ADC by an interface circuit that may include a microprocessor, for example. Subsequent conversions may be initiated by the microprocessor without any modification of the ADC's configuration.

Other applications may be better served by reconfiguring an ADC. For example, an analog-to-digital converter (ADC) system may be employed in an application where a number of analog signals must be converted to digital signals. The various signals may be multiplexed into the ADC for conversion sequentially. Each change in the multiplexor, that is, each change in the selection of analog signals for conversion, is a change in the ADC configuration. In addition to a change in signal source, other configuration changes may be used in a given ADC application. For example, one signal may require greater resolution than another, another require a different reference voltage. Such configuration changes are typically incorporated in the firmware used to direct the operation of a microprocessor that controls and ADC. Although this approach provides for some flexibility in the operation of an ADC, some applications would benefit from even greater flexibility.

An ADC that provides configuration flexibility, permitting the use of various resolutions, input channels, voltage references, and conversion sequences, for example, would be highly desirable.

An analog-to-digital converter (ADC) in accordance with the principles of the present invention includes read/write storage for at least one configuration parameter value. The one or more configuration parameter read/write storage locations are configured to accept configuration information that may be used by control logic to configure the ADC's conversion mechanism. Different configuration information may be downloaded to the read/write storage locations to configure the ADC in a manner that is suited to different applications or circumstances. The read/write storage locations may be organized as lists through which the ADC may cycle to reconfigure itself for the conversion of various signals of interest.

In an illustrative embodiment, an ADC in accordance with the principles of the present invention includes, a conversion mechanism, an input/output (I/O) interface, control logic, read/write storage, at least one analog input channel, and at least one voltage reference input. The conversion mechanism may be any sort of ADC conversion mechanism known in the art, such as a "flash", sigma-delta, integrating, charge-balancing, or successive approximation, for example. The control logic may take the form of combinatorial/sequential logic, a state machine, or a microprocessor such as the core microprocessor of an application specific integrated circuit, for example. The read/write storage may be implemented as non-volatile memory, such as electrically erasable programmable read only memory (EEPROM), flash memory, or battery-backed random access memory, for example. The read/write storage may be used to store configuration parameter values employed by the control logic to control the conversion mechanism.

The parameter values may be organized within the storage as one or more lists, with each list containing configuration parameter values directed to a particular set of conditions. Various list combinations may be employed for different applications. In this way, a standard ADC may be readily "customized" to operate in different applications simply by downloading corresponding sets of parameter lists. Additionally, for a given application, the control logic may select among the lists in order to accommodate changing conditions. For example, different lists may be associated with operation within different ranges of environmental parameter values and, given the values, the control logic might switch among the lists to operate the ADC with the appropriate set of configuration parameters.

The new ADC is particularly well suited for operation in battery monitoring and charging applications. In such applications, an ADC may convert a number of cell voltages, operating current, temperature, and other parameters using a variety of reference voltages. The converted data may be used to determine remaining battery capacity, for example. Not only may the results of these conversions prompt alarms or messages from a battery-monitor, the battery monitor itself may alter its operation. For example, the battery-monitor may measure current (via the ADC) more frequently as the battery is discharged near the end of its useful capacity. In such a case, control logic according to the principles of the present invention may load parameters to the ADC from a list that dictates more frequent current measurement.

In accordance with the principles of the present invention, analog signals are converted to digital signals at different resolutions and frequencies of conversion, depending on a parameter that may be measured or computed. In an illustrative embodiment, a battery monitor employs an ADC to measure the temperature, voltage and current drain of a battery. Based upon these measurements, the battery monitor determines the battery's state-of-charge. In turn, the state-of-charge determines the frequency, sequence, and resolution of the various analog-to-digital conversions. In an illustrative embodiment, the controller employs various configuration lists that determine the frequency and resolution of the parameter measurements. Additionally, the lists may include a selection among various reference voltages. Greater resolution and frequency of measurement may be employed, for example, in the measurement of battery voltage as the remaining battery capacity reaches a critical point, such as fully charged or fully discharged.

Loading a value from a configuration list into the ADC may effect a change in conversion resolution. The frequency of conversion may be implemented within the list or by varying the lists. That is, within each list each parameter to be measured may be converted a different number of times and "read out" at different speeds. So that, for example, the battery voltage may be converted twenty times in a row at the highest conversion speed provided by the ADC, followed by a single temperature conversion, followed by a twenty more voltage readings, followed by a single current reading. By varying the number of times the readings are made within each "configuration list", the frequency of the readings may be varied within the list. The conversion frequency of all parameters may be varied in this manner. Additionally, the conversion frequency of the various parameters may be varied by shuffling through a variety of lists, each of which may include different sequences of conversion. Various combinations of "within-list" conversion frequencies, external-to-list conversion frequencies and modifications of ADC readout speed may be employed to alter the frequency of conversion. The battery monitor may also employ such configuration lists to select among a variety of available voltage references for different analog-to-digital conversions.

An embodiment of the present invention is an analog to digital converter (ADC) comprising:
storage configured to store one or more configuration parameter values;
an analog-to-digital conversion mechanism;
and control logic adapted to configure the analog-to-digital conversion mechanism according to the one or more configuration parameter values stored in said storage.

The storage can be a read/write storage. The plurality of configuration parameters can be stored as one or more lists and the control logic is configured to cycle through at least one list, thereby altering the configuration of the analog-to-digital conversion mechanism. The stored configuration parameter value may controls the selection of an analog input channel from which an analog signal is to be converted to a digital signal. The stored configuration parameter value may control the resolution of an analog-to-digital conversion. The stored configuration parameter value may also control the selection of a reference voltage input from which a reference voltage is obtained for use in an analog-to-digital conversion by the analog-to-digital conversion mechanism. The input port can be adapted for receiving said one or more configuration parameter values for storage in said storage.

A method of converting analog signals to digital signals may comprise the steps of:
(A) storing one or more configuration parameter values; and
(B) control logic configuring an analog-to-digital conversion mechanism according
to the configuration parameter values stored in step (A);

The step of the storing (A) can includes the step of: (A1) storing said one or more configuration parameter values by downloading them to read/write storage included in the ADC that includes the analog-to-digital conversion mechanism. Furthermore, the step of (A2) organizing the stored configuration parameter values as one or more lists can be included. The step of configuring (B) may include the step of : (B1) the control logic cycling through at least one list, thereby altering the configuration of the analog-to-digital conversion mechanism. Furthermore, it may include the step of : (B2) the control logic configuring the analog-to-digital conversion mechanism to select an input channel from which an associated analog signal is to be converted to a digital signal. The step of configuring (B1) may further include the step of: (B3) the control logic selecting the conversion resolution of the analog-to-digital conversion mechanism and/or the step of: (B4) the control logic selecting a reference voltage input from which a reference voltage is obtained for use in an analog-to-digital conversion by the analog-to-digital conversion mechanism. The method may further comprise the step of: the ADC receiving said one or more configuration parameter values through an input port.

Another embodiment is a battery monitor comprising:
one or more sensors adapted for sensing battery characteristics; and
an ADC configured to convert one or more analog signals from the one or more sensors to digital signals, the ADC comprising:
   storage configured to store one or more configuration parameter values; an analog-to-digital conversion mechanism; and
   control logic adapted to configure the analog-to-digital conversion mechanism according to the one or more configuration parameter values stored in said storage.

The one or more sensors can include a voltage sensor adapted to sense the voltage across one or more cells of a battery being monitored. The one or more sensors can also include a temperature sensor adapted to sense the temperature of a battery being monitored. The one or more sensors may also include a current sensor adapted to sense the discharge current of a battery being monitored. The configuration parameter values can be arranged in a plurality of configuration lists and the control logic can be adapted to configure the analog-to-digital conversion mechanism from different lists, depending upon the value of one or more of the sensed battery characteristics. The configuration parameter values can also be arranged in a plurality of configuration lists and the control logic can be adapted to configure the analog-to-digital conversion mechanism from different lists, depending upon the state of charge of the monitored battery.

A method of monitoring a battery may comprise the steps of:
(A) storing one or more ADC configuration parameter values;
(B) sensing one or more characteristics of the battery;
(C) control logic configuring an analog-to-digital conversion mechanism according to the configuration parameter values stored in step (A);
(D) converting an analog signal corresponding to the one or more characteristics sensed in step (B) to a digital signal using the configuration of step (C).

The step of storing may include the step of: (A1) storing said one or more configuration parameter values by downloading them to read/write storage included in the ADC that includes the analog-to-digital conversion mechanism; and/or the step of: (A2) organizing the stored configuration parameter values as one or more lists. The step of configuring may include the step of: (B1) the control logic cycling through at least one list, thereby altering the configuration of the analog-to-digital conversion mechanism; and/or the step of: (B2) the control logic configuring the analog-to-digital conversion mechanism to select an input channel from which an associated analog signal is to be converted to a digital signal. The step of configuring (B1) may further include the step of: (B3) the control logic selecting the conversion resolution of the analog-to-digital conversion mechanism; and/or the step of: (B4) the control logic selecting a reference voltage input from which a reference voltage is obtained for use in an analog-to-digital conversion by the analog-to-digital conversion mechanism. The method may further comprise the step of: the ADC receiving said one or more configuration parameter values through an input port.

Another embodiment is an electronics system comprising:
system electronics;
a battery pack configured to supply power to the system electronics;
a battery charger configured to control charging current supplied to the battery pack;
a battery monitor configured to monitor the battery pack and provide state of charge information related to the battery pack to the battery charger, the battery monitor including:
   one or more sensors adapted for sensing battery characteristics; and
   an ADC configured to convert one or more analog signals from the one or more sensors to digital signals, the ADC comprising:
      storage configured to store one or more configuration parameter values;
      an analog-to-digital conversion mechanism; and
      control logic adapted to configure the analog-to-digital conversion mechanism according to the one or more configuration parameter values stored in said storage.

The one or more sensors can include a voltage sensor adapted to sense the voltage across one or more cells of a battery being monitored. The one or more sensors can further include a temperature sensor adapted to sense the temperature of a battery being monitored. The one or more sensors can also include a current sensor adapted to sense the discharge current of a battery being monitored. The configuration parameter values can be arranged in a plurality of configuration lists and the control logic can be adapted to configure the analog-to-digital conversion mechanism from different lists, depending upon the value of one or more of the sensed battery characteristics. The configuration parameter values can also be arranged in a plurality of configuration lists and the control logic can be adapted to configure the analog-to-digital conversion mechanism from different lists, depending upon the state of charge of the monitored battery.

A method of operating an electronics system may comprise the steps of:
(A) supplying power to the electronics system from a battery pack;
(B) a battery charger controlling charging current supplied to the battery pack;
(C) a battery monitor monitoring the battery pack and providing state of charge information related to the battery pack to the battery charger;
(D) storing one or more ADC configuration parameter values;
(E) sensing one or more characteristics of the battery;
(F) control logic configuring an analog-to-digital conversion mechanism according to the configuration parameter values stored in step (D);
(G) converting an analog signal corresponding to the one or more characteristics sensed in step (E) to a digital signal using the configuration of step (F).

The step of storing (D) can include the step of: (D1) storing said one or more configuration parameter values by downloading them to read/write storage included in the ADC that includes the analog-to-digital conversion mechanism; and/or the step of: (D2) organizing the stored configuration parameter values as one or more lists. The step of configuring (F) can include the step of: (F1) the control logic cycling through at least one list, thereby altering the configuration of the analog-to-digital conversion mechanism. The step of configuring (F1) can include the step of: (F2) the control logic configuring the analog-to-digital conversion mechanism to select an input channel from which an associated analog signal is to be converted to a digital signal; and or the step of: (F3) the control logic selecting the conversion resolution of the analog-to-digital conversion mechanism. The step of configuring (R) can include the step of: (F4) the control logic selecting a reference voltage input from which a reference voltage is obtained for use in an analog-to-digital conversion by the analog-to-digital conversion mechanism. The method may further comprise the step of: (H) the ADC receiving said one or more configuration parameter values through an input port.

The above and further features, aspects, and advantages of the invention will be apparent to those skilled in the art from the following detailed description, taken together with the accompanying drawings in which:
Figure 1 is a conceptual block diagram of an analog-to-digital converter (ADC) in accordance with the principles of the present invention;
Figure 2 is a conceptual block diagram of a pair of configuration parameter lists in accordance with the principles of the present invention;
Figure 3 is a flow chart depicting the process whereby an ADC in accordance with the principles of the present invention utilizes configuration parameter lists;
Figure 4 is a conceptual block diagram of a battery monitor in accordance with the principles of the present invention;
Figures 5A -5E are illustrative lists such as may be employed to configure and ADC in a battery monitor in accordance with the principles of the present invention;
Figure 6 is a flow chart of a battery monitoring/charging process in accordance with the principles of the present invention; and
Figure 7 is a block diagram of an electronic system that employs a battery monitor/charger in accordance with the principles of the present invention.

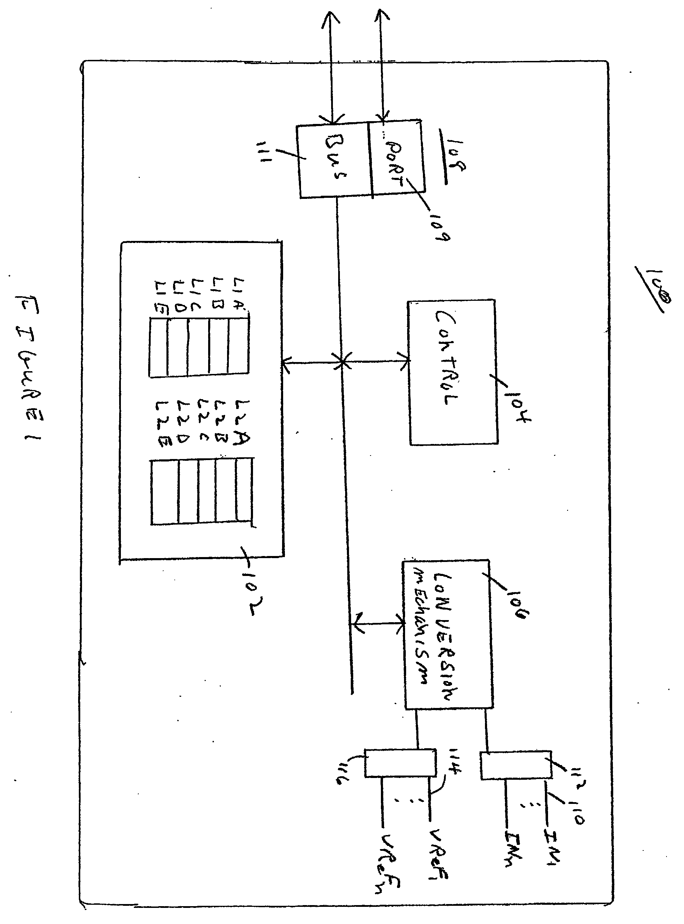

An illustrative embodiment of an analog-to-digital converter (ADC) in accordance with the principles of the present invention is shown in the block diagram of Figure 1. The ADC 100 includes read/write storage 102 for at least one configuration parameter value. The storage 102 may be in the form of non-volatile memory, such as flash, battery-backed, or EEPROM memory, for example. In this illustrative example, ten storage locations are organized as two lists of five locations each, having respective addresses of L1A-L1E and L2A-L2E. Each storage location may be any number of bits wide. For convenience, the storage locations may be organized in byte-wide, or byte-wide multiples. The configuration parameter read/write storage locations L1A-L1E and L2A-L2E are configured to accept configuration information that may be used by control logic 104 to configure the ADC's conversion mechanism 106. The conversion mechanism 106 may be any sort of ADC conversion mechanism known in the art, such as a "flash", sigma-delta, integrating, charge-balancing, or successive approximation, for example.

The control logic 104 may take the form of combinatorial/sequential logic, a state machine, or a microprocessor such as the core microprocessor of an application specific integrated circuit, for example. An input/output (I/O) interface 108 may be employed to interact with other, system-level, components, for example, and may include a communications port 109 through which configuration parameter values may be downloaded for storage in the storage locations L1A-L1E and L2A-L2E. The port 109 may also include a parallel digital output 111, which may be used to transfer results from the ADC 100. One or more input channels 110 may route analog signals 1N1-1Nn to the conversion mechanism 106 for conversion to digital signals. A multiplexor 112 may be included in the signal path to select among the analog input channels for conversion. One or more voltage reference inputs 114 may also be connected through a path that includes a multiplexor 116 that may be employed to select among a plurality of voltage references Vrefl - Vrefn. One or more voltage references, Vrefl - Vrefn, may be integral to the ADC 100 or may be separately packaged and accessed through the voltage reference inputs 114.

Each list of parameter values, located in storage locations L1A-L1E and L2A-L2E, may contain configuration parameter values directed to a different set of conditions. One or more ADCs may be "customized" by downloading one or more lists, such as lists L1A-L1E and L2A-L2E, directed toward a specific application. Different list combinations may be employed for different applications. The term, "Different list combinations," includes lists having the same organization and storage locations, but loaded with different parameter values. It also includes lists having different locations and/or organizations.

For a given application, the control logic 104 may select among the lists L1A-L1E and L2A-L2E in order to accommodate changing conditions. For example, list L1A-L1E may contain ADC configuration data associated with ambient temperatures from 0° to 20°, and list L2A-L2E associated with ambient temperatures from 20° to 30°. In response to information indicating that the temperature has changed from one range to the other, the control logic 104 could switch from one corresponding list to another in order to configure the ADC conversion mechanism appropriately for the circumstances.

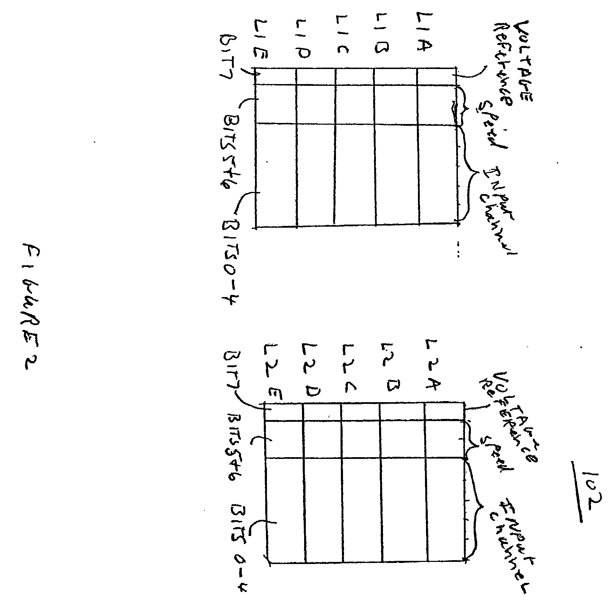

The block diagram of Figure 2 provides a more detailed view of the illustrative configuration lists L1A-L1E and L2A-L2E. The illustrated lists are byte-wide, with three parameter definition fields. Each field is dedicated to a separate configuration parameter related to the ADC conversion mechanism 106. In this illustrative embodiment, bits 0-4 determine the ADC input channel 1N1-1Nn (by controlling the multiplexor 112, for example), bits 5 and 6 determine the conversion speed, by setting the hold time of a sample/hold, for example. Bit 7 determines which of two available reference voltage inputs is used (by controlling the multiplexor 116, for example). The contents of each location, L1A-L1E and L2A-L2E, define the configuration parameters for an ADC conversion.

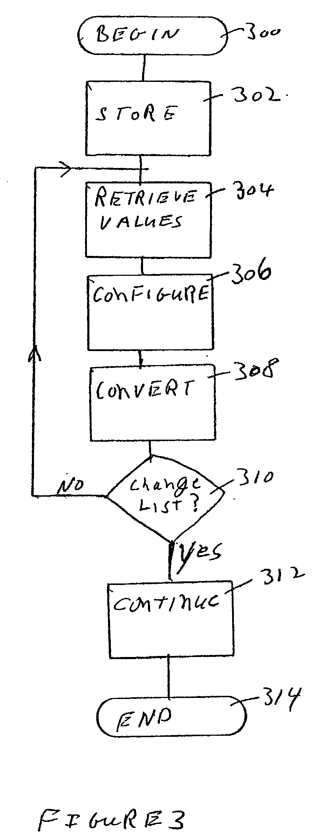

The flow chart of Figure 3 depicts the operation of an ADC in accordance with the principles of the present invention. The process begins in step 300 and proceeds to step 302 where configuration parameter values are stored in the lists, L1 and L2. These values may be downloaded through an input/output interface 108, for example. From step 302 the process proceeds to step 304, where the control logic 104 retrieves configuration parameter values from one of the lists. Initially, the parameter values are obtained from the "top" location in the list, location L1A in this example. This retrieval process may be initiated, for example, by a power-on-reset routine in an embodiment in which the control logic includes a microprocessor. In step 306 the control logic 104 configures the ADC conversion mechanism 106 in conformity with the parameter values retrieved from the storage location L1A. The control logic 104 may effect the configuration, for example, by loading a register that controls the multiplexors, 112, 116, and other configurable elements of the ADC. Other configurable elements may include conversion speed, sample-and-hold configuration, or conversion resolution, for example. Some of the elements may be inter-related, as in the case of a sigma-delta converter in which resolution and conversion speed are inversely related (*i*.*e*., greater resolution implies lower conversion speed).

Once the ADC is configured according to the contents of storage location L1A, the process proceeds to step 308, where the conversion process is initiated. The conversion process may include any of various forms of "hand-shaking", so that, for example, once the conversion process has been initiated, the conversion mechanism 106 alerts the control logic, through an interrupt, for example, that a conversion is complete. The process proceeds from step 308 to step 310 where, once a conversion is complete, the control logic 104 determines which is the appropriate location from which to obtain the next set of configuration parameter values. The completion of a conversion may be determined through a variety of techniques known in the art, such as an interrupt generated by the conversion mechanism or a control logic timer, for example. The results of the conversion may be employed by the control logic, to determine whether conversion parameter values should be obtained from the other list, for example. Additionally, the conversion results may be made available to another functional block or entity and/or stored.

If the control logic 104 determines in step 310 that conditions have not changed in a manner that would require alteration of the normal sequence of conversions, the process returns to step 304 and from there, as previously described, to cycle through the configuration changes associated with analog-to-digital conversions. The determination of step 310 may include input from elements outside the ADC itself, by means of an interrupt, or message received at the I/O interface, for example. The control logic need not return to a configuration parameter list between each ADC conversion; the same configuration data may be employed for more than one conversion. If, in step 310, the control logic 104 determines that a different configuration parameter value list should be employed, the control logic goes to the location of the top of the appropriate list (L2A in this example) to obtain the next set of configuration parameters in step 304 and proceeds from there as previously described. As indicated by the "continue" block of step 312 the process proceeds in this manner indefinitely until, due to a shutdown, for example, it proceeds to end in step 314. Other operations, such as the downloading of additional configuration parameter lists or the modification of existing lists may occur, for example, during the "continue" phase of step 312.

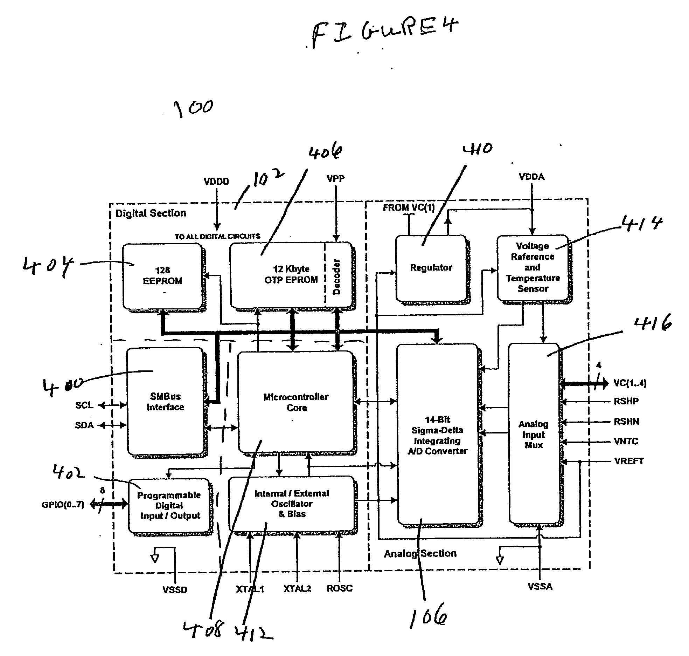

The conceptual block diagram of Figure 4 provides a more detailed view of an ADC 100 in accordance with the principles of the present invention. In this illustrative embodiment, the ADC is employed as a battery monitor and the conversion mechanism 106 is a fourteen bit sigma-delta integrating A/D. The I/O port 108 includes a bus interface 400 and a programmable digital input/output 402. Storage 102 includes EEPROM 404 and a one time programmable (OTP) EPROM 406. The control logic 104 includes a microcontroller core 408. In this battery-monitoring embodiment, the ADC 100 includes a voltage regulator 410 and an oscillator and bias circuitry 412. At least one voltage reference and temperature sensor 414 are included. An input multiplexor 416 operates under control of the microcontroller 408 to select an analog signal of interest for conversion. The analog input signals include four cell voltages Vcell1 Vcell2, Vcell3, and Vcell4. The analog inputs also include shunt resistor inputs VSHN and VSHP, which may be used to sense the current drawn from a battery being monitored, and external thermistor inputs VNTC and VREFT, which may be used to measure the temperature of a battery pack.

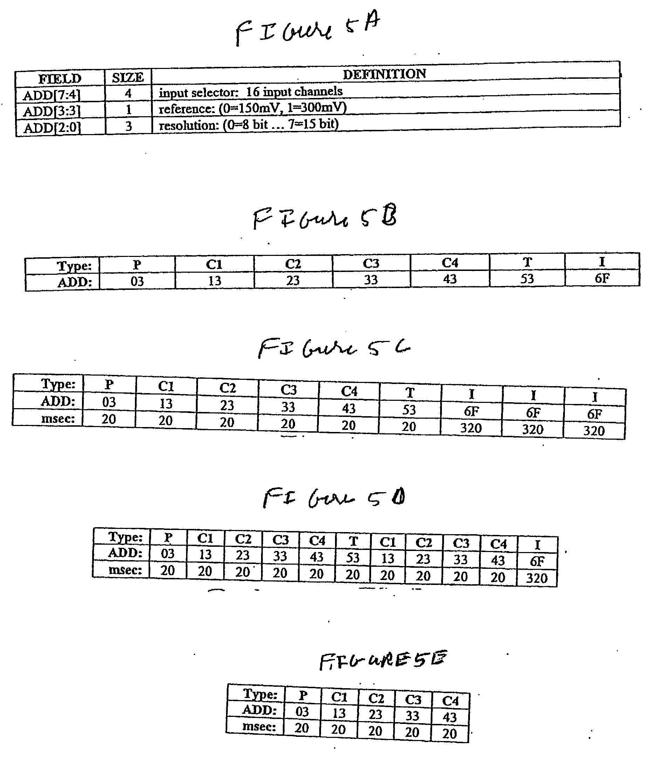

The table of Figure 5A provides an illustrative bit-field definition for configuration parameter values storage in accordance with the principles of the present invention. In this embodiment the three lowest-order bits, bits 0-2 (Analog Digital Definition - ADD), are set aside for the selection of resolution. Selections range from a binary value of "0", which provides 8-bit resolution, to a binary value of "7" (*i.e.*, 111), which provides 15-bit resolution. Bit 3, ADD3, determines whether a 150mV (ADD3 = 0) or a 300mV (ADD3 = 1) reference is employed for the conversion associated with the given ADD entry. Bits 4 through 7 (ADD4 - ADD7) determine which one of sixteen input channels is selected for the analog-to-digital conversion of its associated signal.

The table of Figure 5B illustrates a list of configuration parameter values in accordance with the principles of the present invention. The actual list entries are presented in hexadecimal format (*e*.*g*., the contents of the last list location are "6F", which corresponds to a binary value of "0110 1111"). The entry types, P, C1, C2, C3, C4, T, and I provide a "shorthand" indication of the function associated with the corresponding contents. For example, in this illustrative embodiment, a "P" entry indicates that the analog signal to be converted represents the voltage across an entire battery "pack", that is, from one pole of a cell at one extreme of the pack to the opposite pole of the cell at the other extreme of the pack. Entries C1, C2, C3, and C4 indicate that the analog signals to be converted respectively correspond to the first, second, third, and fourth cells of a multi-cell stack. A current measurement is indicated by an "I" entry, and a temperature measurement is indicated by a "T" entry. By way of example, as indicated by the bit-field definitions described in the discussion related to Figure 5A, all the configuration parameter value entries except an "I", current measurement, entry would configure the ADC conversion mechanism to employ a 150mV reference (ADD3 = 0). A current measurement entry would employ a 300mV reference (ADD3 = 1). A temperature measurement, indicated by a "T" type entry, employs 15-bit resolution, whereas other conversions employ 11-bit resolution.

In operation, the microcontroller 408 would cycle through such a list, reconfiguring the ADC conversion mechanism 106 before each conversion according to the list entry. That is, the first conversion associated with the list of Figure 5B would be a "P"-configured conversion, which would provide a digitized indication of the pack voltage. The following conversion would be a "C1" (cell 1) type of conversion, followed by a "C2" conversion, and so on. A basic conversion parameter list, such as that of Figure 5B could be cycled through repeatedly, with the substantially equal time devoted to the conversion of all analog inputs of interest. In a sigma-delta converter embodiment such as this illustrative example, the conversion speed is inversely related to the conversion resolution. Consequently, a T conversion will take more time than other types of conversion. For the sake of this discussion let us assume that each conversion takes the same amount of time. Given that assumption, cycling through the list would devote one seventh of the conversion time to sampling the pack voltage, one seventh of the time to sampling the voltage of Cell 1, and so on.

The frequency of sampling may be varied by changing the list, by adding another P-type entry, for example, or through other list adjustments. Additionally, a plurality of lists, each having a different set of entries, may be cycled through in order to vary the frequency of measurement. In a battery "fuel gauge" application, current measurements are typically made more frequently than in the example of Figure 5B. Because the list of Figure 5C includes three current measurements, such a list may be better suited to a battery fuel gauge application than the list of Figure 5B. The third row of Figure 5C includes illustrative conversion times for the various configurations. Because all the configurations (P, C1, C2, C3, C4 and T) other than an I-type configuration, which employs fifteen-bit resolution for current measurement, employ eleven-bit resolution, those configurations require 20 millisecond (msec) conversion times. Current measurement, which employs fifteen-bit resolution, requires 320 msec conversion time. In operation, the use of a configuration list such as the list of Figure 5C would devote 89% (960/1080) conversion time current measurements. Other configuration lists and cycling among lists would provide other mixes of conversion time percentages.

As another example, cell voltage is used as the criteria for determining "full" or "empty" status in a Lithium Ion battery pack and cell voltages change more rapidly as the battery approaches either the full or empty state. Consequently, the importance of measuring cell voltages in a Lithium Ion battery pack increases as the battery approaches either the "full" or "empty" state-of-charge. A configuration list, such as that of Figure 5D, may be employed in such circumstances. Such a list yields cell voltage measurements twice every 520 msec, in contrast to once every 1080 msec using the list of Figure 5C.

Other, specialty configuration lists, may be employed for very specific circumstances. The configuration list of Figure 5E may be employed to calibrate pack and cell voltages, for example. Each voltage of interest is measured once every 100 msec in this example and no time is devoted to the measurement of parameters, such as current or temperature, that are not of interest at the time voltages are being calibrated.

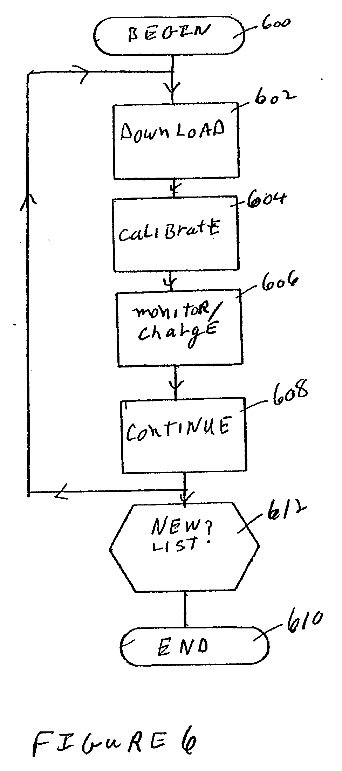

The flow chart of Figure 6 illustrates the operation of a battery monitor/controller in accordance with the principles of the present invention, particularly in relation to the operation of a list-configured ADC, as previously described. The process begins in step 600 then proceeds to step 602 where configuration lists for the ADC are downloaded. In this battery monitor/charger embodiment, the downloaded lists may include configuration lists directed to specific operations, to specific battery chemistries, or to the number of cells in a the battery, for example. The lists may include calibration lists, which emphasize the measurement of cell or battery-pack voltage, and there may be "normal operation", "battery full" and "battery low" lists, for example. After downloading the configuration lists in step 602, the process proceeds to step 604 where the battery monitor/charger is calibrated. Lists downloaded in step 602 may be employed in this calibration process. A system-level calibration, including that of whatever electronic system may be using the battery pack for system power, may be effected in this step too.

From step 604 the process proceeds to step 606 where the monitor/charger undertakes the monitoring and charging of an associated battery. The battery, monitor, and charger may all be incorporated in an electronic device, such as a handheld or laptop computer, for example. The monitor and charging control process may employ any of a variety of techniques known in the art. For example, charging techniques set forth in U.S. Patent No. , issued to , in , or in U.S. Patent No. , issued to , in , which are hereby incorporated by reference in their entirety, may be employed during the monitoring/charging stage of this process. This process may include the use of various ADC configuration lists, as previously described, to alter the ADC configuration parameters and to thereby accommodate charging processes that vary the types of measurement, frequency, resolution, reference voltage, quantity of interest, e.g., depending upon the state-of-charge. The state-of-charge factors may include current, temperature, voltage, and charge/discharge history. The frequency of measurement (measurement entails A/D conversion in this context) may be controlled within a list, by including such measurements more or less frequently within a given list, or by switching from list to list, with some lists including more frequent measurements of a given parameter than others. Generally, the ADC operation during this phase is related to gathering information related to a battery's state-of-charge, issuing alarms, as appropriate, and controlling current flow, when charging current is available. Different ADC configuration lists may be associated with different phases of this operation.

As indicated by the "continue" block of step 608, the monitoring/charging phase could last indefinitely and proceed to end in step 610 only with the end of the battery or the equipment using it. However, as indicated by decision block 612, given the right set of circumstances, the process could return to step 602, where another set of ADC configuration lists is downloaded. Such a downloading may occur, for example, diagnostics are run on the battery, the battery monitor, or the electronic equipment using the battery. Alternatively, the battery monitor could be "swapped out" for use with a different battery pack and that pack may include a different number of cells or different cell chemistry, for example. In that case, the new ADC configuration lists downloaded in step 602 would accommodate the new battery pack.

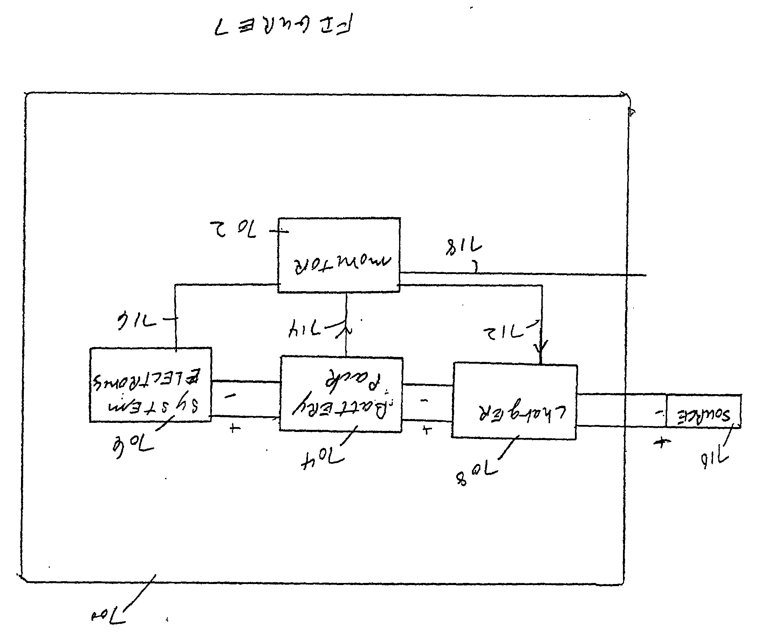

The block diagram of Figure 7 depicts an electronic system 700, which employs a battery monitor/charger in accordance with the principles of the present invention. A battery monitor 702 employs one or more configuration lists as previously described in conjunction with an ADC to measure various parameters associated with a battery-pack 704. The measured parameters might include one or more temperatures, discharge current, or cell and/or pack voltages, for example. Additionally, a plurality of voltage references may be employed in the ADC conversion process, with the selection of voltage reference determined by the contents of the configuration lists. The battery-pack 704 supplies "primary" or "backup" energy to system electronics 706. A battery monitor/charger in accordance with the principles of the present invention may be applied to a wide range of electronic systems 700. For example, the system 700 may range in size and battery capacity from a handheld electronic device to transportation device such as a battery- or hybrid-powered car or bus, to an industrial installation. Monitoring information obtained by the monitor is supplied to a charge controller 708 which controls the amount of charging current supplied to the battery-pack 704 from an external source 710 when that source is available. The monitor 702 may include communications links 712, 714, 716, and 718 to the charger, battery pack, system electronics and external electronics. The link 712 with the charger may be used to convey battery-pack status information and may also permit the charger 708 to query the monitor 702. The link 714 with the battery-pack includes various analog signal lines, which permit the monitor to measure cell voltages, and other parameters as previously described. The link 716 may permit system electronics 706 to download configuration lists to the monitor 702, for example and the link 718 may permit the downloading of configuration lists from external electronics to the monitor.

A software implementation of the above described embodiment(s) may comprise a series of computer instructions either fixed on a tangible medium, such as a computer readable media, *e.g.* diskette, CD-ROM, ROM, or fixed disc, or transmittable to a computer system, via a modem or other interface device, such as communications adapter connected to the network over a medium. Medium can be either a tangible medium, including but not limited to, optical or analog communications lines, or may be implemented with wireless techniques, including but not limited to microwave, infrared or other transmission techniques. The series of computer instructions embodies all or part of the functionality previously described herein with respect to the invention. Those skilled in the art will appreciate that such computer instructions can be written in a number of programming languages for use with many computer architectures or operating systems. Further, such instructions may be stored using any memory technology, present or future, including, but not limited to, semiconductor, magnetic, optical or other memory devices, or transmitted using any communications technology, present or future, including but not limited to optical, infrared, microwave, or other transmission technologies. It is contemplated that such a computer program product may be distributed as a removable media with accompanying printed or electronic documentation, *e.g.*, shrink wrapped software, preloaded with a computer system, *e.g.*, on system ROM or fixed disc, or distributed from a server or electronic bulletin board over a network, e.g., the Internet or World Wide Web.

Although various exemplary embodiments of the invention have been disclosed, it will be apparent to those skilled in the art that various changes and modifications can be made which will achieve some of the advantages of the invention without departing from the spirit and scope of the invention. It will be apparent to those reasonably skilled in the art that other components performing the same functions may be suitably substituted.

Further, the methods of the invention may be achieved in either all software implementations, using the appropriate object or processor instructions, or in hybrid implementations that utilize a combination of hardware logic, software logic and/or firmware to achieve the same results. Processes illustrated through the use of flow charts may not be strictly linear processes and alternative flows may be implemented within the scope of the invention. The specific configuration of logic and/or inst ructions utilized to achieve a particular function, as well as other modifications to the inventive concept are intended to be covered by the appended claims.

The foregoing description of specific embodiments of the invention has been presented for the purposes of illustration and description. It is not intended to be exhaustive or to limit the invention to the precise forms disclosed, and many modifications and variations are possible in light of the above teachings. The embodiments were chosen and described to best explain the principles of the invention and its practical application, and to thereby enable others skilled in the art to best utilize the invention. It is intended that the scope of the invention be limited only by the claims appended hereto.

## Claims

1. An analog to digital converter (ADC) comprising:
storage configured to store one or more configuration parameter values;
an analog-to-digital conversion mechanism;
and control logic adapted to configure the analog-to-digital conversion mechanism according to the one or more configuration parameter values stored in said storage.

2. The ADC of claim 1 wherein the storage is read/write storage.

3. The ADC of claim 1 or 2, wherein a plurality of configuration parameters are stored as one or more lists and the control logic is configured to cycle through at least one list, thereby altering the configuration of the analog-to-digital conversion mechanism.

4. The ADC of claim 3 wherein a stored configuration parameter value controls the selection of an analog input channel from which an analog signal is to be converted to a digital signal.

5. The ADC of claim 3 wherein a stored configuration parameter value controls the resolution of an analog-to-digital conversion.

6. The ADC of claim 3 wherein a stored configuration parameter value controls the selection of a reference voltage input from which a reference voltage is obtained for use in an analog-to-digital conversion by the analog-to-digital conversion mechanism.

7. The ADC according to on of the preceding claims, further comprising an input port adapted for receiving said one or more configuration parameter values for storage in said storage.

8. A method of converting analog signals to digital signals comprising the steps of:
(A) storing one or more configuration parameter values; and
(B) control logic configuring an analog-to-digital conversion mechanism according
to the configuration parameter values stored in step (A);

9. The method of claim 8, wherein the storing of step (A) includes the step of:
(A1) storing said one or more configuration parameter values by downloading them to read/write storage included in the ADC that includes the analog-to-digital conversion mechanism.

10. The method of claim 9, wherein the storing of step (Al) includes the step of:
(A2) organizing the stored configuration parameter values as one or more lists.

11. The method of claim 10, wherein the configuring of step (B) includes the step of:
(B1) the control logic cycling through at least one list, thereby altering the configuration of the analog-to-digital conversion mechanism.

12. The method of claim 11, wherein the configuring of step (B1) includes the step of:
(B2) the control logic configuring the analog-to-digital conversion mechanism to select an input channel from which an associated analog signal is to be converted to a digital signal.

13. The method of claim 11 or 12, wherein the configuring of step (B1) includes the step of:
(B3) the control logic selecting the conversion resolution of the analog-to-digital conversion mechanism.

14. The method according to one of the claims 11-13, wherein the configuring of step (B1) includes the step of:
(B4) the control logic selecting a reference voltage input from which a reference voltage is obtained for use in an analog-to-digital conversion by the analog-to-digital conversion mechanism.

15. The method according to one of the claims 11-14, further comprising the step of:
the ADC receiving said one or more configuration parameter values through an input port.

16. A battery monitor comprising a an analog digital converter according to one of the claims 1-7.

17. An electronic system having a battery monitor as in claim 16.
